Europäisches Patentamt

European Patent Office

Office européen des brevets

(11) Publication number: **0 490 118 A1**

# EUROPEAN PATENT APPLICATION

(21) Application number: **91119515.4**

(22) Date of filing: **15.11.91**

(51) Int. Cl.5: **G03F 7/033**, G03F 7/32, H05K 3/34

(30) Priority: **10.12.90 US 625089**

(43) Date of publication of application: **17.06.92 Bulletin 92/25**

(84) Designated Contracting States: **DE GB IT**

(71) Applicant: **SHIPLEY COMPANY INC. 2300 Washington Street Newton, Massachusetts 02162(US)**

(72) Inventor: **Shipley, Charles R. 71 Vista Avenue Newton, Massachusetts 02166(US)**

(74) Representative: **Bunke, Holger, Dr.rer.nat. Dipl.-Chem. et al Patentanwälte Prinz, Leiser, Bunke & Partner Manzingerweg 7 W-8000 München 60(DE)**

(54) **Photoimagable solder mask and photosensitive composition.**

(57) An aqueous developable light sensitive composition comprising an organic solution of at least one polymer having polar group substitution, a photoinitiator and an unsaturated cross linking or polymerizable monomer. The composition is developable with an aqueous solution of a weak organic acid following exposure to activating radiation and baking. A cured photoimaged mask from said composition has properties suitable for use of the composition as a photoimagable solder mask for printed circuit boards and for serving as a permanent dielectric mask in the manufacture of full additive printed circuit boards. Alternatively, the photoimaged mask can be utilized as a temporary mask for many applications due to its unexpected resistance to harsh chemical solutions including both strong acid and strong alkali solutions, and due to its adhesion to copper and other metals as well as to many nonconductive substrate materials.

## Background of the Invention

### I. Introduction

This invention relates to novel light sensitive compositions useful as temporary or permanent photoimagable masks and for other applications requiring light sensitive coatings. More particularly, this invention relates to a photoimagable solder mask for use in the fabrication of printed circuit boards which may be a temporary or permanent coating. The light sensitive compositions of the invention are characterized by superior bonding properties to copper, superior resistance to corrosive chemical treatment solutions and superior resistance to flow at elevated temperatures encountered in soldering operations.

### II. Description of the Prior Art

Processes for the manufacture of printed circuit boards, which term is used herein to include innerlayers and other circuit structures, are known in the art and described in numerous publications such as Coombs, Printed Circuit Handbook, McGraw-Hill Book Company, New York, 2d Ed., 1976, c. 5 to 8, incorporated herein by reference. Many processes for the manufacture of printed circuit boards are known and many methods have common processing sequences.

The conventional manufacture of printed circuit boards often involves use of chemically harsh treatment solutions and elevated temperatures. Elevated temperatures may be required for the application or reflow of solder onto a circuit. Harsh chemical treatment solutions may include strongly acidic or alkaline etchants and plating solutions. Consequently, in the manufacture of printed circuit boards, processing materials such as organic solder masks are required that are able to withstand attack by strong acid and alkaline chemical treatment solutions and elevated temperatures.

An example of a circuit fabrication procedure where harsh chemicals and elevated temperatures are encountered comprises application of solder to portions of a circuit pattern while providing protection to the underlying circuit and substrate. To apply solder to a circuit, using a photoimagable solder mask for purposes of illustration, the solder mask is applied over the entire surface of a circuit (both on conductive and nonconductive portions of the circuit) and exposed and developed to provide a mask over the entire circuit board except for those portions of the circuit over which solder is to be applied. An acidic flux is often then applied over the copper followed by solder. Solder may be applied by floating the circuit in liquid solder, by wave soldering or by metal deposition. If by metal deposition, the solder is reflowed at elevated temperature subsequent to deposition. The solder mask used must be able to protect the surfaces underlying the mask (copper and dielectric) and therefore must adhere to the surface over which it is coated while withstanding elevated temperatures and corrosive treatment chemicals. For high density circuits, fine line imaging is necessary. In addition, a solder mask should be moisture and insulation resistant, electromigration/denditric growth resistant, possess adequate dielectric strength especially if the mask is to be used as a permanent coating, possess hydrolytic stability, resist ionic contamination, be free of air-bubble entrapment, avoid blistering and resist fungus growth and thermal shock. Finally, it is desirable that a solder mask composition be aqueous developable.

Typical solder mask compositions include aqueous and solvent based epoxy systems, acrylic resin systems and epoxy/acrylic resin combinations. A discussion of solder mask compositions, uses and shortcomings may be found in Photoimagable Solder Mask for SMT, Circuits Manufacturing, August, 1988, pp. 36 - 38; Photoimagable Solder Masks, PC Fab, October, 1990, pp. 110 - 114; An Update on Liquid Photoimagable Solder Masks, Circuits Manufacturing, Sept. 1990, pp. 23 - 31; and Kurisu, High Density solder Mask selection Criteria - A solder Mask Service Viewpoint, Technical Paper No. C8/l presented to the Printed Circuit World Convention U.K. June, 1990, each incorporated herein by reference.

The solder masks of the prior art each possess certain desirable properties, but it is believed that no solder mask composition meets all or even most of the requirements for a solder mask as set forth in the above cited publications.

## Summary of the Invention

The subject invention is for a light sensitive liquid coating composition especially suitable for use as a solder mask. Dry films formed from the light sensitive compositions of the invention are strongly adherent to those copper and insulating substrates encountered in circuit manufacture, are resistant to strong acid and alkali solutions and possess an ability to be developed in mild aqueous acidic solutions within a range of pH of from about 2 to 6. In addition, the light sensitive compositions of the invention are capable of fine line image resolution making them suitable for use in the fabrication of high density circuits. Moreover, the light sensitive compositions of the invention possess good dielectric properties and may be used as permanent coatings. Further, the compositions of the invention are cast from solution over all surfaces of the printed circuit including the copper conductors and the dielectric substrate and firmly adhere to both. Finally, the compositions of the invention possess other properties required for use of the compositions as a solder mask.

The light sensitive coating compositions of the invention are homogeneous organic solutions of a polymer containing one or more polar groups, a photoinitiator and a source of unsaturation capable of undergoing crosslinking or polymerization upon exposure to activating radiation. The source of unsaturation is preferably an unsaturated cross linking or polymerizable monomer, such as, for example, a multifunctional unsaturated monomer. In a lesser preferred embodiment, the source of unsaturation can be present in the polymer component of the light sensitive composition. The solvent is an organic solvent which is defined as a predominant amount of an organic solvent in sufficient quantity to dissolve all solid components. In this respect, the solvent is free of water in an amount that would cause phase separation and more preferably, is essentially free of all water, though water in minor amount (up to 10% by volume of the solvent) may be tolerated if phase separation is not encountered.

Accordingly, it is an object of this invention to provide a light sensitive composition that is especially useful as a solder mask in the manufacture of printed circuit boards.

Another object of this invention is to provide a light sensitive composition that is resistant to attack by corrosive treatment solutions.

A further object of this invention is to provide a light sensitive composition that is strongly adherent to all circuit board surfaces including dielectric surfaces and copper.

An additional object of this invention is to provide a solder mask that is capable of providing fine line image resolution.

A further object of this invention is to provide a solder mask that possesses properties that make the mask suitable for use as either a permanent or temporary coating.

A major object of this invention is to provide an aqueous, developable, photoimagable, permanent dielectric mask useful for producing fully additive printed circuits on nonconductive substrates.

Another object of this invention is to provide a permanent or temporary photoimagable mask for making full additive outer layer circuitry for surface mount technology (SMT) multilayer boards.

An additional object of this invention is to provide presensitized substrates consisting of a substrate coated with a dry coating of the photoimagable composition of the invention.

Another object of this invention is to provide methods for fabricating articles using the light sensitive compositions of the invention.

Other objects and advantages of the invention will be apparent from the description that follows.

Description of the Preferred Embodiments

As described above, the light sensitive compositions of the invention are homogeneous organic solutions of at least one polymer containing polar groups, a photoinitiator and a source of unsaturation for a crosslinking or polymerization reaction upon exposure to activating radiation and baking.

Suitable polymers for use in the light sensitive compositions of the invention are addition or condensation polymers having polar group substitution, preferably basic polar group substitution. Polar group substitution enhances development of the imaged light sensitive composition in an aqueous developer. Addition polymers having polar groups prepared from monomers having ethylenic unsaturation are preferred. Polymers containing polar groups that are useful in the light sensitive composition include acrylic polymers, vinyl polymers other than acrylic polymers, polyesters, and polyimides. Suitable polar groups include, for example, quaternary ammonium groups, amine groups, sulfonium groups, sulfoxonium groups and carboxylic acid groups. By selection of the polar group, the resist can be made developable in mildly acid solution, preferably containing a suitable surfactant, within a pH ranging from about 2 to 6, hereafter defined as essentially neutral development. For acid development, a basic polar group is desired. Amine substitution is preferred. For base development, an acidic polar group would be used.

Acrylic polymers containing polar groups are prepared by the polymerization or copolymerization of acrylic acid, methacrylic acid, the esters or amides thereof, and mixtures of such monomers, provided that at least one monomer contains a polar group. An acrylic polymer bearing polar groups can be prepared by the polymerization of monomers, one of which has a basic amine group, such as 2-(dimethylamino) ethyl methacrylate (DMAEMA), or 3-(dimethylamino) propyl methacrylamide (DMAPMA). Similarly, (meth)acrylic acid polymers bearing acidic polar groups may be prepared from acrylic acid or methacrylic acid monomers alone or with other monomers such as lower alkyl acrylic or methacrylic acid esters where the alkyl groups contained from one to about 8 carbon atoms, for example, methyl methacrylate, butylacrylate and the like. Alternatively, it is also possible to modify polymers having no polar groups to include such groups. For example, a glycidal methacrylate polymer can be reacted with an amine to attach an amine group to the polymer chain.

Vinyl polymers, other than the acrylic or methacrylic polymers described above, incorporating polar groups may also be used. These polymers can be prepared by the polymerization of vinyl monomers such as styrene and substituted styrene, vinyl halides such as vinyl chloride, vinyl esters such as vinyl acetate, and vinyl ethers such as methyl vinyl ether, alone or with other vinyl monomers containing carrier groups such as 2-methylvinylimidazole and vinylimidazole.

It is also possible to prepare polymers that are suitable for the practice of this invention from the polymerization of the acrylic and methacrylic monomers together with the other vinyl monomers, provided that at least one of the monomers contains a polar group.

Epoxy polymers, polyesters and polyurethanes are also useful in the photosensitive polymer composition, but are lesser preferred. Details for their formation are known to the art and may be found in U.S. Patent No. 4,592,816, incorporated herein by reference.

A preferred class of polymers suitable for light sensitive composition use are prepared by the free radical polymerization in a suitable solvent of esters and/or amides of acrylic acid and/or methacrylic acid, where at least one of the monomers contains an amine group. Suitable solvents for the polymerization include the monopropyl ethers of 1,2-propanediol, methyl cellosolve, cellosolve acetate, butyl carbitol, isopropanol, n-butanol, ethylene glycol, acetone, methyl ethyl ketone, ethyl acetate, toluene, xylene, and dimethylsulfoxide, ethyl lactate, propylene glycol monoalkyl ethers.

The polymer or polymer mixture containing polar group substitution desirably contains from at least about 10 milliequivalents of the polar group per 100 grams of the polymer or polymer mixture to less than about 200 milliequivalents of polar group per 100 grams of polymer or mixture in order for a deposited film to be capable of selective development without adversely affecting the exposed areas of the film. Preferably, the polymer contains from about 20 to about 100 meq/100g. Even more preferred are polymers containing from about 25 to about 75 meq/100g.

The molecular weight of the polymers used in the light sensitive composition of the invention are preferably less than 250,000 weight average molecular weight. When acrylic, methacrylic, or the other vinyl polymers are used, the weight average molecular weight should range from about 5,000 to about 200,000, and preferably from about 8,000 to about 100,000 weight average molecular weight.

One particularly preferred polymer mixture in accordance with the invention is formed from about 2 to about 15 weight percent DMAEMA, about 2 to about 43 weight percent ethyl acrylate, and from about 83 to about 55 weight percent methyl methacrylate. These copolymers have a molecular weight of from about 10,000 to about 150,000 and a glass transition temperature of from about 90°C. to about 100°C.

The photosensitive polymer compositions are formed by mixing the polymer with at least one unsaturated multifunctional monomer so that the photosensitive resist film formed is capable of being polymerized by a photoinitiator when exposed to actinic radiation. Unsaturated monomers having two or more unsaturated groups attached to the same molecule are preferred. More preferred are multifunctional monomers having three or more acrylate or methacrylate groups attached to each monomer molecule. Most preferred are tri, tetra and penta multifunctional monomers. Multifunctional oligomers are also useful. The monomer is added to the polymer mixture so that there is sufficient unsaturation to give a Bromine Number of about 35 or greater.

Examples of suitable multifunctional monomers include allyl methacrylate; 1,4-benzenediol dimethacrylate; bisphenol-A diacrylate; 1,3-butanediol diacrylate; 1,4-butanediol diacrylate; butylene glycol dimethacrylate; 1,4-cyclohexanediol dimethacrylate; diethylene glycol diacrylate; di-(3-methacryloxy- ethyl) ether of bisphenol-A; di-(3-methacryloxy-2-hydroxypropyl) ether of 1,4 butanediol; dipropylene glycol dimethacrylate; ethylene glycol diacrylate; hexamethylene glycol dimethacrylate; melamine acrylate; 1-phenyl-1,2-ethanediol dimethacrylate; 1,3 propanediol diacrylate; 1,2-propanediol dimethacrylate; tetraethylene glycol diacrylate; tetraethylene glycol dimethacrylate; triethylene glycol diacrylate; triethylene glycol dimethacrylate; trimethylolethane triacrylate; tripropylene glycol diacrylate; and tris-(2-methacryloxyethyl) isocyanurate. Additional examples of multifunctional monomers can be found in the above-cited U.S. Patent No. 4,592,816.

Preferred unsaturated crosslinking monomers are those where at least one and preferably most of such linkages are conjugated with a double bonded carbon including carbon double bonded to carbon or to such heteroatoms as nitrogen, oxygen and sulfur. The preferred crosslinking monomers are those where the ethylenically unsaturated groups are conjugated with esters or amides, such as pentaerythritol triacrylate and the like.

The light sensitive composition contains a photoinitiator. A photoinitiator is a material that will polymerize the unsaturated groups in the polymer and/or unsaturated crosslinking monomer when exposed to radiation of an appropriate wavelength. Examples of photoinitiators suitable for use in the polymeric composition include the azo compounds, sulfur containing compounds, metallic salts and complexes, oximes, amines, polynuclear compounds, organic carbonyl compounds etc.

The photoinitiators which have been found to be preferred in the photosensitive polymer composition of the invention include: 3-phenyl-5-isoxazolone/benzanthrone; 2-t-butylanthraquinone; 2,2-dimethoxy-2-phenylacetophenone; 1-hydroxycyclohexyl phenyl ketone, and diethoxyacetophenone; 2,4,6-tris (trichloromethyl)-1,3,5-triazine with 3,3'-carbonyl bis (7-diethylaminocoumarin), 1-methyl-2-benzylmethylene-1,2-dihydronaphthol (1,2d) thiazole, or 9-phenylacridine; 2-mercaptobenzimidazole with 9-phenylacridine; and 3-phenyl-5-isoxazoline with 9-fluorenone or 1-methyl-2-benzylmethylene-1,2-dihydronaphtho (1,2d) thiazole. Other useful photoinitiators can be found in the above referenced U.S. Patent No. 4,592,816.

The method for preparation of the light sensitive compositions of the invention is within the skill of the art. A preferred method comprises mixing the polymer with the unsaturated monomer followed by addition of the photoinitiator and dilution of the solution with additional solvent to obtain desired coating properties. Suitable solvents include those identified above. Water may be present in the formulation in minor amount, but if present, is present in an amount insufficient to form a separate phase or dissolve the solid components of the light sensitive composition. Water does not serve to enhance the performance of the light sensitive composition or assist in coating the same onto a substrate.

The concentration of the various components in the light sensitive compositions of the invention may vary within wide limits. The concentration of the solvents in solution is dependent upon the manner in which the light sensitive composition is to be applied to a substrate. Concentration ranges set forth on a weight basis based upon 100 parts of polymer are illustrated in the following table:

|  | Overall | Preferred | Most Preferred |
|---|---|---|---|
| Polymer | 50 - 80 | 60 - 75 | 65 - 70 |
| Unsaturated Monomer | 50 - 20 | 40 - 25 | 35 - 30 |
| Photoinitiator[1] | 1 - 10 | 3 - 8 | 4 - 7 |
| Solvent[2] | 15 - 75 | 25 - 60 | 33 - 50 |

(1) Photoinitiator content based upon 100 parts of polymer and unsaturated monomer.
(2) Sufficient to provide coating composition having the percent solids indicated.

Other additives may be included in the coating composition such as pigments, dyes, inert fillers, surfactants, air release agents, leveling agents, flexibilizing agents, etc. Additional additives that may be contained in the coating composition would be apparent to those skilled in the art. The amount of such optional additives is limited by the effect of such additives on the developing and photoimaging capabilities of dry films formed from the coating composition.

The light sensitive compositions of the invention are cast from organic solution and are capable of coating both a dielectric surface and a conductive surface. For this reason, and others, they are distinguishable from aqueous solutions or emulsions of similar composition disclosed in the above referenced U.S. Patent No. 4,592,816 which are required to be electrodeposited from aqueous solution or emulsion limiting their use to the coating of conductive surfaces. In addition, the light sensitive compositions of the invention do not require protenation of carrier groups and do not require additives that enhance protenation. By substantial reduction or elimination of water from the light sensitive composition, cast and dried films of the light sensitive compositions of the invention have the unexpected properties of enhanced adhesion to substrates, especially copper clad circuit board substrates, and enhanced resistance to strong alkaline and acid solutions.

Since the light sensitive compositions of this invention are not electrodeposited and need not be applied over a conductive surface, they may be applied by a variety of coating procedures including slot coating. The use of slot coating in the manufacture of large area microelectronic circuits is known and disclosed in U.S. Patent No. 4,696,885, incorporated herein by reference. Slot coating of a light sensitive composition, as disclosed in this cited patent, comprises extruding a substantially continuous, relatively viscous liquid coating capable of maintaining its form and integrity between its discharge point from the extruder or slot and its point of contact on the surface of a circuit base material. The extruder or slot is an orifice that is an elongate horizontal orifice. A circuit board base material passes linearly past the orifice and with a direction of movement essentially perpendicular to the slot as light sensitive composition is discharged from the orifice. Typically, the linear velocity of the circuit board base material to be coated is somewhat greater than the linear velocity of the light sensitive composition web or coating discharged through the orifice whereby the light sensitive composition film is drawn down between the orifice and the circuit board base material. In practice, the light sensitive composition passes through the orifice at a somewhat greater thickness, i.e., the thickness of the orifice, and the higher linear velocity of the circuit board material to be coated thins and stretches the film of light sensitive composition to form a deposited film of somewhat lesser thickness. The light sensitive composition is forced through the orifice or slot by imposing a hydrostatic head across the orifice to force the light sensitive composition out of and through the orifice and onto the circuit board base material. The film of light sensitive composition is formed in close proximity to the surface to be coated, for example, from about 0.002 inch to about 0.01 inch from the surface to be coated, although it may be formed at a further distance from the circuit board base material dependent upon the rheological properties of the light sensitive composition.

Following coating of the light sensitive composition of the invention onto a substrate, whether by casting, slot coating, curtain coating, etc., the coated substrate is exposed and developed to transfer an image, such as a pattern delineated on a photomask, onto a substrate. Exposure of the film can be carried out at atmospheric pressure by placing the photomask in contact with the light sensitive composition coating and exposing the coating through the mask to desired radiation or alternatively, using off contact procedures as is known to those in the art. Exposure of the light sensitive composition coating is preferably carried out under partial pressure by placing the light sensitive composition coated substrate and photomask in a frame capable of sustaining at least a partial vacuum and having a window transparent to exposing radiation. When the vacuum is applied, the seal that the window rests on is compressed so that the window presses the mask firmly into contact with the light sensitive composition film. The exposing radiation, such as unfiltered ultraviolet light produced by a mercury lamp having an average wavelength of between about 300 and 400 nm, can be used to expose the photosensitive coating through the photomask.

Following exposure and removal of the photomask, the light sensitive composition coating is developed by subjecting the coating to an aqueous developing solution either by spraying the developer onto the coating or by immersion of the light sensitive composition coated substrate into an aqueous acidic developing solution. Developing solutions that have been found to be useful include from about 1 to about 15% aqueous solution of an organic acid such as acetic acid, glycolic acid, formic acid, succinic acid and lactic acid, lactic acid being preferred. More preferred is the use of the organic acid in combination with a suitable surfactant which permits lower concentration of the acid in the developer. The developer solutions used are typically used at temperatures ranging from about 20°C to about 50°C. During development, agitation is desired.

Spray development is a preferred method of development and may be conducted by pumping the developer through a spray nozzle onto the surface of the exposed light sensitive composition coated substrate. The unexposed film is then removed by the sprayed developer. Following development, the substrate surface is then rinsed and dried with air, nitrogen or heat.

In addition to the chemical resistance of the light sensitive compositions of the invention, the light sensitive compositions have additional properties that make their use advantageous over other solder masks and light sensitive coatings in the marketplace used for the fabrication of printed circuit boards. They provide fine line image resolution, have excellent dielectric properties and are readily developed by immersion in a developer to provide a clean image without leaving residues on the bared substrate surfaces. In comparison, for many solder masks used for the manufacture of printed circuit boards, especially those used in the form of a dry film, impingement or spray development is required for development.

The dielectric constant of the light sensitive compositions of the invention make the light sensitive compositions suitable for use as permanent dielectric coatings. In this respect, the light sensitive compositions of the invention have dielectric constants typically in the range of 3 to 4. For this reason, following formation of a circuit, dependent upon the process used, it is not necessary to remove the light sensitive composition. Instead, it can be retained on the circuit board as a permanent dielectric coating.

The invention will be better understood by reference to the following examples where Example 1 represents the preferred embodiment of a composition of the invention.

Example 1 - Formation of Light Sensitive Composition

Four hundred grams of propylene glycol methyl ether solvent may be placed in a four-neck round bottom flask fitted with a mechanical stirrer, nitrogen inlet tube, condenser and thermometer. Nitrogen gas may then be bubbled through the solvent and exhausted through an oil bubbler attached to the condenser to degas the solvent and flush the air from the reaction vessel. The nitrogen inlet tube may then be raised above the level of the solvent and a flow maintained to keep a positive pressure of nitrogen in the flask throughout the reaction. A thermostatically controlled heating mantle may then be fitted to the underside of the flask and the solvent heated to 105°C. A mixture of 48 grams of 2-(dimethylamino) ethyl methacrylate, 408 grams of methyl methacrylate and 162 grams of butyl acrylate and 6.2 of t-butyl peroctoate, a free radical initiator, may be added dropwise over a 4 hour period to the stirred reaction vessel. An additional 0.6 grams of t-butyl peroctoate (10% of the originally added amount) may be then added to the reaction vessel within about 20 minutes after addition of all of the monomers. The heating and stirring may then be maintained for another thirty minutes and then discontinued. At the end of the reaction time, complete conversion of the monomers to the polymers should have occurred. The polymer solution is then diluted with additional solvent to make a solution containing 50% solids. A solder mask is then prepared as follows:

|  | weight | solids |
|---|---|---|
| Polymer Solution | 100.0 | 50.0 |
| 50% solution of reaction product of dimethylaminoethyl methacrylate (8 parts), methyl methacrylate (68 parts), butyl acrylate (11.8 parts) and vinyl acetate (1 part) |  |  |
| Monomer |  |  |
| Dipentaerythritol pentaacrylate | 24.0 | 24.0 |
| Photoinitiators |  |  |
| 2-methyl-1-[4-(methylthio)-phenyl] -2-morpholino-propan-1-one | 4.5 | 4.5 |
| 2-Isopropylthioxanthone (1.5 parts) | 1.5 | 1.5 |
| Solvent | 71.0 | 0 |
| Propylene glycol monomethyl ether acetate |  |  |
| Totals | 200.0 | 80.0 |

The components identified above may be mixed together in any order desired. In addition, fillers such as titanium dioxide are desired additives to such a composition used as a solder mask. The mask is capable of passing the IPC moisture insulation test known to be a severe test of a solder mask. The imaged mask is also capable of passing soldering tests, including solder flotation at 500°F for 10 seconds, solder flotation at 550°F for 10 seconds, wave soldering, and the particularly severe hot air solder leveling process to which solder masks are subjected.

Example 2 - Use as a Photoimagable Solder Mask

A solder mask having a composition essentially that of the composition of Example 1 was curtain coated onto a conventional printed circuit board test panel having copper conductors on one side with line widths and spaces as narrow as 6 mils. Following photoimaging of the coating, the photoimagable solder mask protected the copper conductors and the epoxy circuit board base material, but not the areas to be soldered. The imaged test panel was then cured for 60 minutes at 120°C.

The light sensitive compositions of the invention are also suitable for use as masks in processes that do not involve a soldering operation, but wherein harsh chemical environments are encountered for sustained

7

periods of time and where strong adhesion to copper is necessary. For example, one method for the manufacture of printed circuit boards involves "print and etch" or subtractive techniques. Using these procedures, a copper clad dielectric substrate is coated with an organic light sensitive coating in a relief pattern defining a desired copper circuit. Thereafter, copper not protected by the organic resist coating is etched with an etchant to remove unprotected copper. Following etching, the organic resist is removed leaving copper beneath the mask in a desired circuit pattern.

In the above described print and etch process, before the light sensitive masking composition is coated over the copper, the copper must be carefully pretreated to promote adhesion between it and the organic resist. If the resist fails to adhere to the copper during the step of etching, the resist may lift off the copper resulting in etching copper beneath the mask, i.e. - in areas where etching is not desired. A typical copper cleaning sequence is discussed by Coombs, ibid, pages 6-7 to 6-9 and involves the steps of vapor degreasing, mechanical cleaning such as by scrubbing with pumice or sanding, high pressure rinsing with deionized water, chemical cleaning such as with an acid or alkaline solution, microetching to produce a clean, pink surface suitable for bonding to the organic resist and finally, in many applications, use of a copper adhesion promoter that applies a thin, hydrophobic film that must be removed prior to substrate treatment steps that conventionally follow development of the light sensitive film.

Following cleaning of the copper clad substrate and formation of an imaged organic mask, the underlying copper bared by development of the light sensitive coating is etched with a chemical etchant. One preferred etchant is an alkaline ammonia etchant which has found increased acceptance by the industry because of an ability to continuously operate the same, minimum undercut of the etched copper lines, a high capacity for dissolved copper and a fast etch rate. Though alkaline ammonia etchants are preferred for many applications, many aqueous developing light sensitive compositions, especially those applied as dry films, are unable to withstand sustained attack by strong alkaline solutions. These films often fail because of etchant attack, substandard adhesion to the underlying copper metal, mechanical scarring, unwanted residue in developed areas, or substandard resolution caused by lateral developer undercut. These films also fail when used as a mask for electroplating solutions such as copper pyrophosphate, precious metal plating solutions that contain alkaline cyanide and other alkaline solutions.

Additive procedures for the manufacture of printed circuit boards utilize strongly alkaline electroless copper plating solutions. In such procedures, a circuit pattern is defined over a substrate by use of a light sensitive mask and the substrate with the coating is immersed in a metal plating solution for a sustained period of time adequate to permit plating of metal to a necessary thickness. The mask used must be capable of withstanding such strongly alkaline baths for sustained times.

Regardless of the method used to fabricate a printed circuit board, it is desirable to use an aqueous developing photoimagable mask that is chemically resistant to highly acid and alkaline solutions for sustained periods of time, capable of providing fine line definition, and capable of development with aqueous developers.

It is an unexpected discovery of this invention that use of the light sensitive compositions of this invention provides a dried coating having chemical resistance and adhesion to an underlying copper substrate significantly improved compared to electrodeposited coatings of similar composition (as taught in the above cited U.S. Patent No. 4,592,816) without sacrifice in other desirable properties such as image resolution, film forming properties, etc. As to adhesion, it has been found that the light sensitive compositions of the invention adhere more tenaciously to copper than similar light sensitive compositions electrodeposited from aqueous solution or emulsion even if the conventional and required step of scrub cleaning is omitted from the steps of preparing the copper for coating with the light sensitive composition. This is highly desirable because, for fine line imaging of printed circuit board clad substrates, physical cleaning such as by scrubbing is harmful in that the surface is scarred, scratched or otherwise marred. It is an advantage of this invention that the step of scrubbing may be omitted which makes the resists of the invention more suitable for printed circuit board fabrication, especially for fabrication of fine line circuits. With respect to resistance to harsh chemical environments, it has been found that dried films of the light sensitive compositions of the invention have at least four times or more resistance to ammoniacal spray etchants than comparable light sensitive composition films electrodeposited from aqueous solution or emulsion. For these reasons, the light sensitive compositions of this invention are especially suitable as masks in the manufacture of printed circuit boards using subtractive and additive processes.

Example 3 - <u>Use as a Permanent Mask in an Additive Process</u>

An epoxy laminate having a resin rich surface was used as a substrate. The substrate was pretreated and immersed in a tin palladium plating catalyst for 5 minutes, rinsed and dried. The photoimagable composition having a composition similar to that of Example 1 was applied and dried to provide a dry film thickness of about 60 microns. After photoimaging, the coating was cured at 120°C for 60 minutes. The part was then immersed in an accelerator for the catalyst at ambient temperature for 5 minutes, rinsed and immersed in a full build, alkaline electroless copper bath for a total of 12 hours during which time copper was selectively deposited over the bared catalyst to form copper circuitry having a thickness of about 50 microns with the imaged photomask serving as a permanent dielectric material.

Example 4 - Use as a Temporary Mask in an Additive Process

The procedure of Example 3 was repeated except that after the full build electroless copper plating step, the imaged mask was removed thereby baring the underlying catalyzed epoxy substrate. The residual catalyst was removed by immersing the part for about 1 minute in a dilute solution of hydrochloric acid (250 ml concentrated acid/750 ml water) containing 30 grams of dissolved cupric chloride. When spacings between the conductor lines are narrow, removal of the catalyst restores the dielectric properties of the epoxy substrate.

Example 5 - Use as a Permanent Mask in a Semi-Additive Process

A two-sided etched printed circuit substrate containing circuits on both sides and non-plated through holes may be pretreated and immersed in a tin-palladium catalyst for 5 minutes, rinsed and dried. The photoimagable composition similar to that of Example 1 may then be applied and dried, first on one side and then on the other side of the printed circuit substrate, to provide a dry film thickness of about 60 microns on both sides. After photoimaging to bare the holes and hole pads, the permanent mask coating may be cured at a temperature of about 120°C for 60 minutes. The part may then be immersed in an accelerator for the catalyst at ambient temperature for 5 minutes, rinsed and immersed in a full build alkaline electroless copper bath at 65°C for a total of 12 hours during which time copper will selectively deposit on the hole sidewalls and in the hole pad areas to form copper plated through hole interconnections having a thickness of about 50 microns, with the imaged mask serving as a permanent solder mask.

Example 6 - Use as a Temporary Photoimagable Mask in a Subtractive Process

A substrate having 1 ounce copper cladding on one side was immersed in a copper cleaner Neutra-Clean 68 cleaner for 3 minutes, rinsed in water, immersed in Preposit 748 Micro Etch for one minute, rinsed and air dried. The light sensitive composition of Example 1 was then coated over the copper using a Meier rod. Following application of the resist to the surface of the copper cladding, the resist was dried for 30 minutes at 90°C, pattern exposed and developed in a spray etch machine using a conventional alkaline ammonia etchant at a temperature of about 120°F for 1 minute. There was no attack on the organic mask.

The above procedure was repeated but the developed image over the substrate was processed through the etch machine four successive times to determine attack on the resist coating. Following the fourth pass through the etching machine, the part was examined and though there was excessive undercut due to over etching of the copper, the exposed mask was not attacked by the etchant solution nor damaged by the conveyor.

In the above, it should be noted that a step of scrub cleaning was not used to prepare the copper cladding for coating with the mask composition. This is considered necessary using prior art mask compositions.

Example 7 - Use as a Temporary Photoimagable Mask in a Subtractive Process (Comparative Example)

A. Electrodeposited Mask - A composition suitable for electrodeposition was prepared in accordance with the procedures set forth in the above-cited U.S. Patent No. 4,592,186. A 1 ounce copper clad epoxy laminate was precleaned by means of scrub cleaning as conventionally used in the printed circuit industry. The light sensitive composition was electrodeposited on the copper clad laminate to a thickness of about 7 microns following the procedure set forth in the referenced patent. Thereafter, the coating was dried and the dry coating photoimaged, developed, rinsed and dried. The part was then spray etched in a conventional alkaline ammonia etchant solution for about 75 seconds at about 120°F. The mask lifted off and peeled from the copper clad substrate.

The procedure was repeated with the laminate precleaned by means of immersing the same in an aqueous solution identified as Neutra Clean 68 Cleaner available from Shipley Company Inc. The part was so treated for 3 minutes, then rinsed and immersed in a micro etch identified as Preposit 768 Micro Etch available from Shipley Company Inc. Following micro etching for a time of 1 minute, the part was then rinsed and dried. Again, spray etching caused the mask to lift off or peel from the copper.

Again, a 1 ounce copper clad epoxy laminate was precleaned and treated with an adhesion promoter as typically used in the printed circuit industry. Following the procedure set forth above, after spray etching, satisfactory results were achieved. However, when the parts were passed through the spray etch machine twice, adhesion was marginally acceptable. Three passes through the spray etch machine caused the mask to lift off the substrate.

B. Organic Coating Composition - A photoimagable solvent based coating composition was prepared in accordance with the procedures of Example 1 using the same polymer, monomer and photoinitiators as used in the electrodeposited emulsion composition set forth above. The composition had a solids content of 36% in propylene glycol methyl ether. The coating composition was coated onto 1 ounce copper clad epoxy laminate to a dry film thickness of about 8 microns. The part was then dried at 90°C for 30 minutes in a convection oven to remove the organic solvent. Prior to coating the part with the photoimagable composition, the parts had been precleaned in Neutra Clean 68 Cleaner for 3 minutes, rinsed, micro etched in Preposit 768 Micro Etch for 1 minute, rinsed and dried. The parts were then spray etched in an alkaline ammonia etch solution at 120°F for about 75 seconds. The parts were examined and it was found that adhesion to the substrate was excellent despite the fact that no adhesion promoter had been used. A part was then passed through the etching cycle for a total of 4 passes. Adhesion of the imaged photoimagable mask was still excellent though some undercutting was observed due to the extreme over etching of the part.

The mask compositions of this invention and dry films formed therefrom are stable over extended periods of time. For this reason, the composition may be coated over various substrates and stored. This permits manufacture and sale of precoated substrate materials such as precoated unclad and copper clad printed circuit board substrates, precoated anodized aluminum, precoated ceramics and precoated metal substrates such as steel, aluminum, zinc, copper, brass or magnesium.

Example 8 - Presensitized Substrate

A two-sided copper clad innerlayer laminate was coated with a composition essentially that of Example 1 to a dry film thickness of about 7 microns, first on one side and then on the other side. To protect the presensitized substrate from light, a peelable protective opaque film was laminated to both sides of the innerlayer. As an alternative to use of the protective opaque film, the presensitized innerlayer laminate can be packaged in a suitable light-proof package.

The coated innerlayer laminate may be shipped to a printed circuit manufacturer where the protective film would be peeled, the laminate selectively photoimaged, etched, followed by removal of the photoimaged mask thereby forming a multilayer board innerlayer. Because of the thin photoimagable coating and because of the high resolution capability of the photoimagable composition, exceptionally fine-line innerlayer circuitry can be produced.

**Claims**

1. A process for the manufacture of an article of manufacture, said process comprising the steps of:
   (a) providing a substrate to be altered in an image pattern;
   (b) coating said substrate from a homogeneous organic solvent solution of an aqueous developable, negative acting, light sensitive admixture comprising at least one polymer having polar group substitution, an unsaturated cross linking or polymerizable monomer or oligomer and a photoinitiator capable of initiating photopolymerization of the mixture upon exposure to activating radiation, and drying said coating;
   (c) exposing the light sensitive coating so formed to a source of activating radiation in an image pattern and developing the same with an aqueous acidic developer; and
   (d) altering the bared underlying substrate.

2. The process of claim 1 where the polymer is free of ethylenic unsaturation.

3. The process of claim 1 where the polar group substitution is with a basic group.

4. The process of claim 3 where the light sensitive admixture is a solder mask and the substrate is altered

10

by application of solder thereto.

5. The process of claim 3 where the light sensitive admixture is a permanent dielectric coating, the substrate is an unclad dielectric and the substrate is altered by plating electroless copper onto the substrate.

6. The process of claim 3 where the light sensitive admixture is a temporary coating, the substrate is an unclad dielectric, and the substrate is altered by plating electroless copper onto the substrate prior to removal of the temporary coating.

7. The process of claim 3 where the light sensitive admixture is temporary, the substrate is a copper clad dielectric and the substrate is altered by etching copper.

8. The process of claim 3 where the polymer component of the light sensitive admixture comprises one or more acrylic polymers.

9. The process of claim 3 where the light sensitive admixture is developable in a mild acid solution.

10. The process of claim 9 where the polymer component is substituted with an amino group.

11. The process of claim 9 where the developer is an aqueous solution of a mild organic acid.

12. The process of claim 3 where the polymer component of the light sensitive admixture is substituted with amine polar groups and the composition is developed with a mild acid solution having a pH ranging between about 2 and 6.

13. The process of claim 3 where the monomer contains one or more ethylenically unsaturated groups conjugated with esters or amides.

14. The process of claim 1 where the light sensitive admixture is cast from solution.

15. The process of claim 1 where the light sensitive admixture is slot coated from solution.

16. The process of claim 1 where the light sensitive admixture is curtain coated from solution.

17. The process of claim 3 where the substrate is an unclad dielectric and is altered by plating electroless copper onto the substrate.

18. The process of claim 17 where the metal plating solution is a alkaline electroless copper plating solution having a pH in excess of 12.

19. The process of claim 7 where the substrate is altered by sustained contact with an alkaline etchant.

20. A process for the manufacture of a printed circuit board, said process comprising the steps of:
    (a) providing a printed circuit board base material;
    (b) coating the entire surface of the printed circuit board base material with a homogeneous solution of an aqueous developable, negative acting, light sensitive admixture comprising an organic solvent solution of at least one polymer having polar group substitution, an unsaturated cross-linking or polymerizable monomer or oligomer and a photoinitiator capable of initiating photopolymerization of the mixture upon exposure to activating radiation, and drying said coating;
    (c) exposing said coating to a source of activating radiation in an image pattern and developing the same with an aqueous mildly acidic organic developer; and
    (d) altering the bared underlying substrate by contact with an acid or alkaline treatment solution or by means of hot molten solder.

21. The process of claim 20 where the light sensitive admixture is free of ethylenic unsaturation.

22. The process of claim 21 where the polymer component of the light sensitive admixture comprises one or more acrylic polymers.

23. The process of claim 22 where the polymer component is substituted with a basic polar group.

24. The process of claim 23 where the developer is an aqueous solution of lactic acid.

25. The process of claim 22 where the polymer component is substituted with an amino group.

26. The process of claim 22 where the monomer contains one or more ethylenically unsaturated groups conjugated with esters or amides.

27. The process of claim 22 where the polymer component of the light sensitive admixture is substituted with amine polar groups and the composition is developed with a mild acid solution having a pH ranging between about 2 and 6.

28. The process of claim 22 where the light sensitive admixture is cast from solution.

29. The process of claim 22 where the light sensitive admixture is slot coated from solution.

30. The process of claim 22 where the light sensitive admixture is curtain coated from solution.

31. The process of claim 22 where the substrate is an unclad dielectric printed circuit board base material, the light sensitive admixture is used as a photoimagable mask and the substrate is altered by metal deposition including a step of sustained contact with an alkaline metal plating solution.

32. The process of claim 31 where the metal plating solution is a alkaline electroless copper plating solution having a pH in excess of 12.

33. The process of claim 22 where the mask is a permanent mask.

34. The process of claim 22 where the mask is a temporary mask.

35. The process of claim 22 where the substrate is a copper clad circuit board base material and the copper is altered by sustained contact with an alkaline etchant.

36. The process of claim 22 where the substrate is a printed circuit and is altered by coating with molten solder.

37. An aqueous developable, negative-acting light sensitive composition comprising an organic solution of at least one polymer and having polar group substitution, one or more unsaturated, multifunctional cross-linking or polymerizable monomer or oligomer and a photoinitiator capable of initiating photopolymerization of the mixture upon exposure to activating radiation, said composition being characterized by developability following coating and drying with an aqueous solution of a weak organic acid.

38. The composition of claim 36 where the polymer is free of ethylenic unsaturation.

39. The composition of claim 37 where the polymer component comprises one or more acrylic polymers.

40. The composition of claim 37 where the polymer component is substituted with a basic polar group and the light sensitive composition is developable in a mild acid solution.

41. The composition of claim 40 where the acid solution is an aqueous solution of lactic acid.

42. The composition of claim 37 where the polymer component is substituted with an amino group.

43. The composition of claim 37 where the monomer contains one or more ethylenically unsaturated groups conjugated with esters or amides.

**44.** The composition of claim 37 where the polymer component of the composition is substituted with amine polar groups and the composition is developed with a mild acid solution having a pH ranging between about 2 and 6.

**45.** The composition of claim 37 as a solder mask.

**46.** The composition of claim 37 as a permanent dielectric coating.

**47.** The composition of claim 45 containing an inert filler.

**48.** A presensitized substrate comprising a substrate coated on one or both of its surfaces with a dry film formed from an organic solution of at least one polymer having polar group substitution, one or more unsaturated, multifunctional cross linking or polymerizable monomers or oligomers, and a photoinitiator capable of initiating photopolymerization upon exposure to activating radiation.

**49.** The article of claim 48 further coated with an opaque, peelable film.

**50.** The article of claim 49 where the substrate is a dielectric.

**51.** The article of claim 50 where the substrate is a printed circuit board substrate.

**52.** The article of claim 49 where the substrate is a copper clad printed circuit board substrate.

**53.** The article of claim 49 where the substrate is anodized aluminum.

**54.** The article of claim 49 where the substrate is metal.

**55.** The article of claim 54 where the metal is selected from the group of steel, aluminum, zinc, copper, brass and magnesium.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 249 857 (BASF AKTIENGESELLSCHAFT)<br><br>* page 10, line 2 - page 10, line 4; claims; example 1 *<br>* page 10, line 41 - page 11, line 5 *<br>--- | 1-16, 20-30, 33,34, 36-40, 43-46 | G03F7/033<br>G03F7/32<br>H05K3/34 |
| Y,D | EP-A-0 176 356 (HAAS AND ROHM COMPANY)<br><br>* claims *<br>--- | 1-16, 20-30, 33,34, 36-40, 43-46 | |
| A | EP-A-0 171 630 (INTERNATIONAL BUSINESS MACHINES CORP.)<br>* claims; figure 1 *<br>--- | 48-55 | |
| A | PATENT ABSTRACTS OF JAPAN<br>vol. 13, no. 59 (P-826)(3407) 10 February 1989<br>& JP-A-63 249 840 ( TOYOBO CO LTD ) 17 October 1988<br>* abstract *<br>--- | 48-55 | TECHNICAL FIELDS SEARCHED (Int. Cl.5)<br><br>G03F<br>H05K |
| A | WORLD PATENTS INDEX LATEST<br>Week 3381,<br>Derwent Publications Ltd., London, GB;<br>AN 81-598240<br>& JP-A-50 138 901 (FUJI PHOTO FILM CO LTD)<br>* abstract *<br>--- | 41 | |
| A | EP-A-0 361 409 (MITSUBISHI RAYON CO., LTD.)<br>* abstract *<br>--- | 48 | |
| A | EP-A-0 041 640 (E.I. OU PONT DE NEMOURS AND COMPANY)<br>* claims; example 1 * | 1-55 | |

The present search report has been drawn up for all claims

| Place of search | Date of completion of the search | Examiner |
|---|---|---|
| THE HAGUE | 20 FEBRUARY 1992 | HILLEBRECHT D. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
....................................................................
& : member of the same patent family, corresponding
   document

EPO FORM 1503 03.82 (P0401)